# EUROPEAN PATENT APPLICATION

(11) **EP 4 404 276 A1**
(43) Date of publication of application: **24.07.2024**
(21) Application number: 22869716.5
(22) Date of filing: 03.08.2022
(51) Int. Cl.: H01L 29/868, H01L 29/201, H01L 29/861

(54) **P-N JUNCTION DIODE**

(30) Priority: 17.09.2021 JP 2021152316
(71) Applicant: Tamura Corporation, Tokyo 178-8511 (JP); Novel Crystal Technology, Inc., Sayama-shi, Saitama 350-1328 (JP)
(72) Inventor: TAKATSUKA, Akio, Sayama-shi, Saitama 350-1328 (JP); SASAKI, Kohei, Sayama-shi, Saitama 350-1328 (JP)
(74) Representative: Betten & Resch
(86) International application number: PCT/JP2022/029845
(87) International publication number: WO 2023/042568

(57) **Abstract**

Provided is a p-n junction diode which can achieve both of the achievement of a low turn-on voltage and the reduction in a leak current even when the p-n junction diode has a simple structure. In one embodiment, a p-n junction diode 1 is provided, which is provided with an n-type semiconductor layer 11 that is composed of a single crystal of an n-type semiconductor having a chemical composition represented by the formula: (GaₓAl_{y}In_{1-x-y})₂O₃ (0 < x ≤ 1, 0 ≤ y < 1, 0 < x+y ≤ 1) and a p-type semiconductor layer 12 that forms a p-n junction with the n-type semiconductor layer 11 and is composed of a p-type semiconductor selected from Cu₂O, NiO, Ag₂O, Ge, SiₓGe₁₋ₓ (0 < x < 1), CuInO₂, CuGaO₂, CuAlO₂, CuAlₓGa_{y}In_{1-x-y}O₂ (0 < x ≤ 1, 0 ≤ y < 1, 0 < x+y ≤ 1) and CuO, and which has a turn-on voltage of 1.2 V or less.

## Description

### Technical Field

The present invention relates to a pn junction diode.

### Background Art

A pn junction diode in which an n-type semiconductor layer formed of a Ga₂O₃-based single crystal and a p-type semiconductor layer formed of NiO are stacked is conventionally known (see Patent Literature 1). Since it is difficult to form p-type Ga₂O₃, a NiO single crystal which can form a pn heterojunction with the Ga₂O₃-based single crystal is used as the material of the p-type semiconductor layer in the pn junction diode described in Patent Literature 1.

Patent Literature 1 also discloses a trench junction barrier Schottky (JBS) diode that includes an n-type semiconductor layer formed of a Ga₂O₃-based single crystal and having trenches, and p-type semiconductor layers buried in the trenches of the n-type semiconductor layer. In general, Schottky barrier diodes can have lower turn-on voltage (or threshold voltage) in forward characteristics as compared to pn junction diodes, but have a problem that leakage current may occur due to the tunnelling phenomenon at the Schottky junction interface. In the JBS diode of Patent Literature 1, leakage current caused by the tunnelling phenomenon at the Schottky junction interface is suppressed by a pn junction between the n-type semiconductor layer and the p-type semiconductor layers in the trenches, and low turn-on voltage and suppression of leakage current are both achieved.

### Citation List

### Patent Literatures

Patent Literature 1: JP 2019/36593A

### Summary of Invention

However, since the JBS diode described in Patent Literature 1 has a complicated structure in which the p-type semiconductor layers are buried in the trenches, complicated steps are required for its production.

It is an object of the invention to provide a pn junction diode that can achieve both low turn-on voltage and suppression of leakage current even when having a simple structure.

To achieve the abovementioned object, an aspect of the present invention provides pn junction diodes defined in (1) to (4) below.
(1) A pn junction diode, comprising:
   an n-type semiconductor layer comprising a single crystal of an n-type semiconductor having a composition represented by (GaₓAl_{y}In_{1-x-y})₂O₃ (0<x≤1, 0≤y<1, 0<x+y≤1); and
   a p-type semiconductor layer that forms a pn junction with the n-type semiconductor layer and comprises a p-type semiconductor comprising Cu₂O, NiO, Ag₂O, Ge, SiₓGe₁₋ₓ (0<x<1), CuInO₂, CuGaO₂, CuAlO₂, CuAlₓGa_{y}In_{1-x-y}O₂ (0<x≤1, 0≤y<1, 0<x+y≤1), or CuO,
      wherein a turn-on voltage thereof is not more than 1.2V
(2) A pn junction diode, comprising:
   an n-type semiconductor layer comprising a single crystal of an n-type semiconductor having a composition represented by (GaₓAl_{y}In_{1-x-y})₂O₃ (0<x≤1, 0≤y<1, 0<x+y≤1); and
   a p-type semiconductor layer that forms a pn junction with the n-type semiconductor layer and comprises a p-type semiconductor comprising polycrystalline Si or amorphous Si,
   wherein a turn-on voltage thereof is not more than 1.2V
(3) A pn junction diode, comprising:
   an n-type semiconductor layer comprising a single crystal of an n-type semiconductor having a composition represented by (GaₓAl_{y}In_{1-x-y})₂O₃ (0<x≤1, 0≤y<1, 0<x+y≤1); and
   a p-type semiconductor layer that forms a pn junction with the n-type semiconductor layer and comprises a p-type semiconductor comprising monocrystalline Si,
   wherein a turn-on voltage thereof is not more than 1.2V
(4) The pn junction diode defined in any one of (1) to (3), wherein electron affinity χₚ and work function ϕₚ of the p-type semiconductor and electron affinity χₙ and work function ϕₙ of the n-type semiconductor satisfy a condition expressed by a formula 0eV≤χₙ-χₚ+ϕₚ-ϕₙ≤1.2eV

### Advantageous Effects of Invention

According to the invention, it is possible to provide a pn junction diode that can achieve both low turn-on voltage (or low threshold voltage) and suppression of leakage current even when having a simple structure.

### Brief Description of Drawings

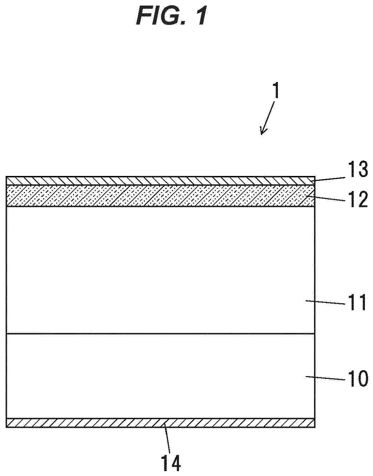

FIG. 1 is a vertical cross-sectional view showing a pn junction diode in an embodiment of the present invention.

### Description of Embodiments

### (Embodiment)

### (Configuration of a pn junction diode)

FIG. 1 is a vertical cross-sectional view showing a pn junction diode 1 in an embodiment of the invention. The pn junction diode 1 includes an n-type semiconductor layer 11 formed of a single crystal of an n-type Ga₂O₃-based semiconductor, and a p-type semiconductor layer 12 that forms a pn junction with the n-type semiconductor layer 11 and is formed of a p-type semiconductor.

The Ga₂O₃-based semiconductor here is Ga₂O₃ or is Ga₂O₃ doped with one or both of Al and In, and has a composition represented by (GaₓAl_{y}In_{(1-x-y)})₂O₃ (0<x≤1, 0≤y<1, 0<x+y≤1). Ga₂O₃ has a wider band gap when doped with Al and a narrower band gap when doped with In. The single crystal of the Ga₂O₃-based semiconductor constituting the n-type semiconductor layer 11 typically has a β-crystal structure.

The n-type semiconductor layer 11 is formed of a single crystal of an n-type Ga₂O₃-based semiconductor, as described above. Here, "formed of a single crystal" means that the entire or substantially the entire portion of the layer is one single crystal, and aggregates of many fine single-crystal grains or flakes do not fall into this category. Since the n-type semiconductor layer 11 is formed of a single crystal of a Ga₂O₃-based semiconductor, the pn junction diode 1 can achieve a characteristic on-resistance with a value close to an ideal value determined by material performance. However, if the n-type semiconductor layer 11 having the same carrier concentration and thickness is formed using an aggregate of fine single-crystal flakes in place of the above-mentioned single crystal of a Ga₂O₃-based semiconductor, the characteristic on-resistance of the pn junction diode 1 is considered to be several times higher than when using above-mentioned single crystal of a Ga₂O₃-based semiconductor, hence, it is not practical.

In the example shown in FIG. 1, the n-type semiconductor layer 11 is a layer formed of a single crystal of an n-type Ga₂O₃-based semiconductor epitaxially grown on an n-type semiconductor substrate 10, and the p-type semiconductor layer 12 is stacked on the n-type semiconductor layer 11. Then, an anode electrode 13 is formed on a surface of the p-type semiconductor layer 12 opposite to the n-type semiconductor layer 11, and a cathode electrode 14 is formed on a surface of the n-type semiconductor substrate 10 opposite to the n-type semiconductor layer 11.

The pn junction diode 1 utilizes the rectification property of a pn junction between the n-type semiconductor layer 11 and the p-type semiconductor layer 12. The turn-on voltage of the pn junction diode 1 is not more than 1.2V The turn-on voltage of the pn junction diode 1 is also, e.g., not less than 0.3V The turn-on voltage here is voltage at the intersection of a straight line, which connects two points at the current density of 1×10² cm⁻² and 2×10² cm⁻² on the curve showing the current density-voltage characteristics and is extrapolated, and the horizontal axis (a straight line with the current density of 0 cm⁻²).

In the pn junction diode 1, a potential barrier at an interface between the p-type semiconductor layer 12 and the n-type semiconductor layer 11 as viewed from the n-type semiconductor layer 11 is lowered by applying forward voltage between the anode electrode 13 and the cathode electrode 14 (positive potential on the anode electrode 13 side), allowing a current to flow from the anode electrode 13 to the cathode electrode 14. On the other hand, when reverse voltage is applied between the anode electrode 13 and the cathode electrode 14 (negative potential on the anode electrode 13 side), the current does not flow due to the potential barrier between pn.

The n-type semiconductor substrate 10 is a substrate formed of a single crystal of an n-type Ga₂O₃-based semiconductor. The n-type semiconductor substrate 10 includes a donor impurity such as Si or Sn. The donor concentration in the n-type semiconductor substrate 10 is, e.g., not less than 1.0×10¹⁸ cm⁻³ and not more than 1.0×10²⁰ cm⁻³. The thickness of the n-type semiconductor substrate 10 is, e.g., not less than 10 µm and not more than 600 µm.

The n-type semiconductor layer 11 formed of an n-type Ga₂O₃-based single crystal includes a donor impurity such as Si or Sn. The donor concentration in the n-type semiconductor layer 11 is, e.g., not less than 1×10¹³ cm⁻³ and not more than 1×10¹⁸ cm⁻³. The thickness of the n-type semiconductor layer 11 is, e.g., not less than 1 µm and not more than 100 µm.

In order to make the pn junction diode 1 have the turn-on voltage of not more than 1.2 V, electron affinity χₚ and work function ϕₚ of the p-type semiconductor, which is the material of the p-type semiconductor layer 12, and electron affinity χₙ and work function ϕₙ of the n-type semiconductor, which is the material of the n-type semiconductor layer 11, preferably satisfy a condition expressed by a formula 0eV≤χₙ-χₚ+ϕₚ-ϕₙ≤1.2eV such that the height of the potential barrier between the anode electrode 13 and the cathode electrode 14, which corresponds to the theoretical value of the turn-on voltage, is not more than 1.2 V The work function mentioned above is equal to the energy difference between the vacuum level and the Fermi level.

χₙ of (GaₓAl_{y}In_{(1-x-y)})₂O₃ (0<x≤1, 0≤y<1, 0<x+y≤1) which is the material of the n-type semiconductor layer 11 is about 0.7 to 4.5 eV and can be adjusted within this range by the composition ratio (values of x, y, and z). ϕₙ can be adjusted by the composition ratio (x, y, z) and the carrier concentration Nd in the n-type semiconductor layer, and is about 0.7 to 5.5 eV

The p-type semiconductor which is the material of the p-type semiconductor layer 12 is, e.g., Cu₂O, NiO, Ag₂O, Si, Ge, SiₓGe₁₋ₓ (0<x<1), CuInO₂, CuGaO₂, CuAlO₂, CuAlₓGa_{y}In_{1-x-y}O₂ (0<x≤1, 0≤y<1, 0<x+y≤1), or CuO. Here, these p-type semiconductors may be any of polycrystalline, monocrystalline, amorphous.

The p-type semiconductor which is the material of the p-type semiconductor layer 12 is preferably polycrystalline Si or amorphous Si. When polycrystalline Si or amorphous Si is used as the p-type semiconductor, a most-mature well-known film deposition technique such as the CVD method or the plasma CVD method can be used, and because it is the mature technology, the p-type carrier concentration can be controlled more accurately by the dopant flow rate.

It is known that p-type monocrystalline Si film can be deposited on (AlₓGa_{y}In_{1-x-y})₂O₃ substrate by using the CVD technique, as described in Non-Patent Literature "H. M. Manasevit and W. I. Simpson: "Single-Crystal Silicon on a Sapphire Substrate" JAP Vol.35 p.1349-1351, 1964". However, immediately after epitaxial growth of Si film, numerous lattice defects occur at the interface on the Si film side due to lattice mismatch between (AlGaIn)₂O₃ single crystal and monocrystalline Si. Non-Patent Literature "M. L. Burgener and R. E. Reedy: "Minimum charge FET fabricated on an ultrathin silicon on sapphire wafer" United States Patent No.5,416,043, 1995" describes a method in which steps such as ion implantation and high temperature annealing are performed after epitaxial growth of Si film to remove these lattice defects, but there is a problem that the these steps are complicated and the process cost is high. In contrast, where a film of p-type polycrystalline Si or p-type amorphous Si is deposited on (AlₓGa_{y}In_{1-x-y})₂O₃ substrate, it is possible to use various known methods such as the CVD method, the plasma CVD method, the sputtering method and it is unnecessary to conduct the defect recovery process such as ion implantation which is needed when depositing the above-described p-type monocrystalline Si film. Therefore, it is possible to perform the film deposition more easily.

The p-type semiconductor which is the material of the p-type semiconductor layer 12 may be monocrystalline Si. For the monocrystalline Si, inexpensive and high-quality p-type monocrystalline Si with a controlled carrier concentration is commercially available. In addition, the p-type semiconductor layer 12 formed of monocrystalline Si can be bonded to the n-type semiconductor layer 11 at room temperature by the surface activated bonding method, and a pn junction can be formed by a safe process that does not use an explosive source gas or carrier gas which is used in CVD apparatus.

Table 1 below shows the electron affinity χₚ and the work function ϕₚ of materials that can be used as the material of the p-type semiconductor layer 12. The value of ϕₚ can be adjusted in the ranges shown in Table 1 by changing the acceptor concentration in the p-type semiconductor layer 12. When the material of the p-type semiconductor layer 12 is monocrystalline SiₓGe₁₋ₓ, polycrystalline SiₓGe₁₋ₓ or amorphous SiₓGe₁₋ₓ, χₚ and ϕₚ can also be adjusted by the composition ratio x.

**Table 1**

| | Electron affinity [eV] | Work function [eV] |
|---|---|---|
| Cu₂O | 3.2 | 5.1 - 5.4 |
| Polycrystalline Si | 4.05 | 4.9 - 5.2 |
| Monocrystalline Si | 4.05 | 4.9 - 5.2 |
| Amorphous Si | 3.9 | 4.7 - 5.3 |
| Polycrystalline Ge | 4.0 | 4.4 - 4.7 |
| Monocrystalline Ge | 4.0 | 4.4 - 4.7 |
| Amorphous Ge | 4.0 | 4.4 - 4.7 |
| Polycrystalline SiₓGe₁₋ₓ | 4.0 - 4.05 | 4.4 - 5.2 |
| Monocrystalline SiₓGe₁₋ₓ | 4.0 - 4.05 | 4.4 - 5.2 |
| Amorphous SiₓGe₁₋ₓ | 3.9 - 4.05 | 4.4 - 5.3 |
| NiO | 1.8 | 5.2 - 5.5 |
| Ag₂O | 3.84 | 4.7 - 5.1 |
| CuO | 4.07 | 5.2 - 5.5 |
| CuInO₂ | 3.6 | 0.8 - 1.5 |
| CuGaO₂ | 1.8 - 2.8 | 3.9 - 5.5 |
| CuAlO₂ | 2.0 | 2.4 - 3.2 |

To form the p-type semiconductor layer 12, it is possible to use, e.g., sputtering method, vacuum deposition, MBE, PLD, CVD, direct bonding, sol-gel method, spray method, and coating method. With the sputtering and vacuum deposition methods, the process cost is relatively low but it is relatively difficult to obtain a film with high crystallinity due to the characteristics of the deposition method and it is difficult to obtain a desired carrier concentration. Film deposition of Cu₂O by the sputtering method is possible, e.g., in the manner described in Non-Patent Literature "Applied Physics Letters 111, 093501 (2017)". On the other hand, with MBE, PLD, and CVD, the process cost is high but it is possible to relatively easily obtain single crystals, and since the background impurity gas concentration can be kept relatively low, it is relatively easy to obtain desired electrical characteristics. Polycrystalline Si, amorphous Si, polycrystalline Ge and amorphous Ge can be deposited by known methods such as the CVD method. In the direct bonding, a high-quality p-type semiconductor layer prepared in advance can be used. Regarding the sol-gel method, when, e.g., NiO is deposited by this method, it is possible to use, e.g., the method described in Non-Patent Literature "Y Kokubun, S. Kubo, S. Nakagomi, Applied Physics Express 9, 091101 (2016)".

Here, a specific example of a configuration to make the pn junction diode 1 to have the turn-on voltage of not more than 1.2V will be described. When, e.g., the n-type semiconductor which is the material of the n-type semiconductor layer 11 is monocrystalline Ga₂O₃ and the p-type semiconductor which is the material of the p-type semiconductor layer 12 is polycrystalline Si, the turn-on voltage of the pn junction diode 1 becomes about 0.9 V by setting the donor concentration in the n-type semiconductor layer 11 to 2×10¹⁶ cm⁻³ and the acceptor concentration in the p-type semiconductor layer 12 to 1×10¹⁸ cm⁻³. When the n-type semiconductor which is the material of the n-type semiconductor layer 11 is (Al_{0.37}Ga_{0.62})₂O₃ and the p-type semiconductor which is the material of the p-type semiconductor layer 12 is polycrystalline Ge, the turn-on voltage of the pn junction diode 1 becomes about 1.0V by setting the donor concentration in the n-type semiconductor layer 11 to 1×10¹⁷ cm⁻³ and the acceptor concentration in the p-type semiconductor layer 12 to 1×10¹⁷ cm⁻³.

As described above, to make the pn junction diode 1 to have the turn-on voltage of as low as not more than 1.2V, it is required to use a single crystal of a Ga₂O₃-based semiconductor as the material of the n-type semiconductor layer 11 and to combine the materials of the anode electrode 13 and the cathode electrode 14 such that the height of the potential barrier therebetween becomes not more than 1.2V, and when these conditions are not satisfied, it is not possible to obtain the turn-on voltage of not more than 1.2V

For example, in the pn junction diode described as Example 1 in Patent Literature 1 (JP 2019/36593A) mentioned above, the n-type semiconductor layer is formed of Ga₂O₃ with a carrier concentration of 6×10¹⁶ cm⁻³, and the p-type semiconductor layer is formed of NiO. In this pn junction diode, since the electron affinity χₙ of Ga₂O₃ is 4.0 eV, the electron affinity χₚ of NiO is 1.8 eV, the work function ϕₙ of Ga₂O₃ is about 4.1 eV and the work function ϕₚ of NiO is about 5.2 to 5.5 eV, the height of the potential barrier corresponding to the theoretical value of the turn-on voltage derived from χₙ-χₚ+ϕₚ-ϕₙ is about 3.3 to 3.6V, hence, the turn-on voltage will never be not more than 1.2V

The anode electrode 13 is formed of a conductive material such as Pt or Ni which forms an ohmic junction with the p-type semiconductor layer 12. The thickness of the anode electrode 13 is, e.g., not less than 0.01 µm and not more than 10 µm.

The cathode electrode 14 is configured such that a portion in contact with the n-type semiconductor substrate 10 is formed of a conductive material such as Ti which forms an ohmic junction with a Ga₂O₃-based single crystal. That is, the cathode electrode 14 when having a single layer structure is entirely formed of Ti, etc., and the cathode electrode 14 when having a multilayer structure is configured such that a layer in contact with the n-type semiconductor substrate 10 is formed of Ti, etc. The multilayer structure of the cathode electrode 14 is, e.g., Ti/Au, Ti/Al, Ti/Ni/Au, or Ti/Al/Ni/Au. The thickness of the cathode electrode 14 is, e.g., not less than 0.01 µm and not more than 5 µm. When the pn junction diode 1 does not include the n-type semiconductor substrate 10 and the cathode electrode 14 is directly connected to the n-type semiconductor layer 11, the n-type semiconductor layer 11 is in ohmic contact with the cathode electrode 14.

### (Effects of the embodiment)

The pn junction diode 1 in the embodiment described above can achieve both low turn-on voltage and suppression of leakage current even when having a simple stacked structure as shown in FIG. 1. Therefore, for example, a power converter circuit such as AC-DC converter with low power loss and high reliability can be manufactured using the pn junction diode 1.

Loss during current conduction through diode is proportional to forward voltage V_{F}, and this V_{F} during current conduction is calculated by adding a voltage component V_{R}, which is obtained by multiplying the characteristic on-resistance by the current density, to the turn-on voltage Vtn. For example, SiC Schottky barrier diodes with a breakdown voltage of 600V which are currently on the market have Vₜₕ of about 0.9V and characteristic on-resistance of about 1 mΩcm². Thus, when a current is conducted at a current density of 400 A/cm², V_{F} is 1.3V

On the other hand, gallium oxide diodes have a figure of merit which is about 10 times that of SiC diodes since the Baliga's figure of merit of gallium oxide is said to be about 3444 while the Baliga's figure of merit of SiC is 340. Therefore, the pn junction diode 1 can achieve the characteristic on-resistance of about 0.1 mΩcm², and if Vₜₕ is not more than 1.2 V, V_{F} when conducting a current at a current density of 400 A/cm² is not more than 1.24V which is lower than V_{F} of the SiC Schottky barrier diodes described above. That is, conduction loss can be smaller than in the SiC Schottky barrier diodes described above.

In addition, the pn junction diode 1, which is a gallium oxide pn diode, can be easily manufactured at low cost by the melt growth method and it is also possible to use bulk wafers which are easy to machine, hence, the pn junction diode 1 is superior in terms of ease of manufacture as compared to SiC Schottky barrier diodes which require the use of materials that are expensive to manufacture bulk wafers and difficult to process.

Therefore, if the pn junction diode 1 has Vₜₕ of not less than 1.2V and is better than SiC Schottky barrier diodes in terms of both electrical performance and ease of manufacture, the pn junction diode 1 can be used in place of SiC Schottky barrier diodes in fields in which SiC Schottky barrier diodes are currently applied.

Although the embodiment of the invention has been described, the invention is not intended to be limited to the embodiment, and the various kinds of modifications can be implemented without departing from the gist of the invention. For example, the structure of the pn junction diode 1 is not limited to that shown in FIG. 1 as long as it is a structure including a pn junction between the n-type semiconductor layer 11 and the p-type semiconductor layer 12. In addition, the shapes of the n-type semiconductor layer 11 and the p-type semiconductor layer 12 and their positions in the pn junction diode 1 are not particularly limited.

In addition, the invention according to claims is not to be limited to the embodiment described above. Further, it should be noted that not all combinations of the features described in the embodiment are necessary to solve the problem of the invention.

### Industrial Applicability

Provided is a pn junction diode that can achieve both low turn-on voltage and suppression of leakage current even when having a simple structure.

### Reference Signs List

1 PN JUNCTION DIODE
10 N-TYPE SEMICONDUCTOR SUBSTRATE
11 N-TYPE SEMICONDUCTOR LAYER
12 P-TYPE SEMICONDUCTOR LAYER
13 ANODE ELECTRODE
14 CATHODE ELECTRODE

## Claims

1. A pn junction diode, comprising:
an n-type semiconductor layer comprising a single crystal of an n-type semiconductor having a composition represented by (GaₓAl_{y}In_{1-x-y})₂O₃ (0<x≤1, 0≤y<1, 0<x+y≤1); and
a p-type semiconductor layer that forms a pn junction with the n-type semiconductor layer and comprises a p-type semiconductor comprising Cu₂O, NiO, Ag₂O, Ge, SiₓGe₁₋ₓ (0<x<1), CuInO₂, CuGaO₂, CuAlO₂, CuAlₓGa_{y}In_{1-x-y}O₂ (0<x≤1, 0≤y<1, 0<x+y≤1), or CuO, wherein a turn-on voltage thereof is not more than 1.2V

2. A pn junction diode, comprising:
an n-type semiconductor layer comprising a single crystal of an n-type semiconductor having a composition represented by (GaₓAl_{y}In_{1-x-y})₂O₃ (0<x≤1, 0≤y<1, 0<x+y≤1); and
a p-type semiconductor layer that forms a pn junction with the n-type semiconductor layer and comprises a p-type semiconductor comprising polycrystalline Si or amorphous Si,
wherein a turn-on voltage thereof is not more than 1.2V

3. A pn junction diode, comprising:
an n-type semiconductor layer comprising a single crystal of an n-type semiconductor having a composition represented by (GaₓAl_{y}In_{1-xy-})₂O₃ (0<x≤1, 0≤y<1, 0<x+y≤1); and
a p-type semiconductor layer that forms a pn junction with the n-type semiconductor layer and comprises a p-type semiconductor comprising monocrystalline Si,
wherein a turn-on voltage thereof is not more than 1.2V

4. The pn junction diode according to any one of claims 1 to 3, wherein electron affinity χₚ and work function ϕₚ of the p-type semiconductor and electron affinity χₙ and work function ϕₙ of the n-type semiconductor satisfy a condition expressed by a formula 0eV≤χₙ-χₚ+ϕₚ-ϕₙ≤1.2eV
